# FASCICULE DE BREVET EUROPEEN

(11) **EP 1 081 864 B1**
(45) Date de publication et mention de la délivrance du brevet: **26.01.2005**
(21) Numéro de dépôt: 00203010.4
(22) Date de dépôt: 29.08.2000
(51) Int. Cl.: H03M 7/16

(54) **Procédé d'encodage binaire /thermométrique**
Verfahren zur binär-thermometrischen Umkodierung
Binary to thermometric encoding method

(30) Priorité: 31.08.1999 FR 9910955
(43) Date de publication de la demande: 07.03.2001
(73) Titulaire: Koninklijke Philips Electronics N.V., 5621 BA Eindhoven (NL)
(72) Inventeur: Guyot, Benoît, 75008 Paris (FR); Janik, Jean-Marie, 75008 Paris (FR)
(74) Mandataire: Chaffraix, Jean

(56) Documents cités:
- GB-A- 233 171
- US-A- 5 283 580
- US-A- 5 345 234
- US-A- 5 657 018
- US-A- 5 706 008
- US-A- 5 717 349

## Description

La présente invention concerne un procédé pour convertir un mot binaire en un signal thermométrique.

On dit d'un signal qu'il est thermométrique lorsqu'il est de nature numérique et que, lorsqu'il est encore possible d'incrémenter ledit signal, on peut trouver parmi les bits qui le composent un bit particulier tel que tous les bits de poids inférieur à celui dudit bit particulier sont à un premier niveau logique, alors que ledit bit particulier et tous les bits ayant un poids supérieur audit bit sont à un deuxième niveau logique, une incrémentation ou une décrémentation de la valeur du signal thermométrique provoquant respectivement un incrémentation ou une décrémentation du poids du bit particulier. Des procédés de conversion binaire/thermométrique sont couramment mis en oeuvre au sein de dispositifs de natures diverses, parmi lesquels des dispositifs destinés à convertir un signal d'entrée numérique en un signal de sortie analogique de type mixte. Un dispositif de type mixte comprend :
. une première et une deuxième batterie de sources de courant, dont des sorties sont interconnectées et sont destinées à délivrer le signal de sortie du dispositif, et
. un encodeur thermométrique destiné à fournir un signal de sortie pour contrôler la conduction de la première batterie de sources de courant, et à recevoir un mot binaire d'entrée constitué par les bits de poids faible du signal numérique d'entrée, les bits de poids fort dudit signal étant destinés à contrôler la conduction de la deuxième batterie de sources de courant.
Les procédés de conversion binaire/thermométrique classiques font généralement appel à un réseau de portes logiques. En effet, la valeur de chaque bit composant le signal thermométrique peut être considérée comme étant régie par une équation logique faisant intervenir des bits du mot binaire d'entrée. Chaque bit du signal thermométrique peut donc provenir d'une sortie d'une chaîne de portes logiques dont des entrées reçoivent des bits du mot binaire d'entrée.

La mise en oeuvre d'un tel procédé de conversion binaire/thermométrique présente des inconvénients majeurs. Tout d'abord, le réseau de portes logiques nécessaire à ladite conversion est encombrant et donc coûteux, à la fois en termes de surface de silicium requise pour sa réalisation et en termes de consommation d'énergie. Par ailleurs, le transfert des informations au travers des chaînes de portes logiques n'est pas instantané et induit des retards de décodage significatifs, qui ne peuvent être réduits qu'en augmentant la taille, et donc la consommation énergétique, des portes logiques utilisées. Dans l'état actuel de la technique, l'utilisation d'un tel procédé de conversion devient irréaliste pour des fréquences de variation du mot binaire d'entrée supérieures à 100MHz. Enfin, la valeur de chacun des bits du signal thermométrique étant régie par une équation qui lui est propre, les chaînes de portes logiques ne sont pas identiques entre elles et présentent des temps de transit différents d'un chaîne à l'autre, ce qui signifie que tous les bits du signal thermométrique ne prendront pas simultanément la valeur qui devrait être la leur, provoquant ainsi des transitions parasites dans la valeur du signal thermométrique, et donc également dans la valeur de signal de sortie du convertisseur numérique/analogique. Ce type d'erreurs de conversion est évidemment à proscrire.

Le document US 5 657 018 divulge un convertisseur binaire/thermométrique comprennant les portes logiques.

La présente invention a pour but de remédier dans une large mesure à ces inconvénients en proposant un procédé de conversion binaire/thermométrique qui ne nécessite pas de réseau de portes logiques pour son implémentation.

En effet, un procédé de conversion binaire/thermométrique conforme au paragraphe introductif est caractérisé selon l'invention en ce qu'il comporte les étapes suivantes :
. conversion du mot binaire en un signal analogique, et
. comparaison dudit signal analogique avec une pluralité de signaux de référence.

Dans un procédé de ce type, les bits du signal de sortie sont tous générés de la même manière et ne présentent donc pas de retards de commutation significatifs les uns par rapport aux autres. De plus, les étapes de conversion et de comparaison peuvent être opérées au moyen de structures simples, qui sont donc peu coûteuses et n'induisent pas de retards de décodage importants.

Dans une variante de l'invention, un procédé tel que décrit plus haut est caractérisé en ce qu'il comporte en outre, insérée entre les étapes de conversion et de comparaison, une étape de mémorisation du signal analogique.

La mémorisation du signal analogique permet, dans une large mesure, d'immuniser le procédé de conversion binaire/thermométrique contre des transitions parasites du mot binaire d'entrée, qui se produisent lorsque tous les bits dudit mot binaire ne prennent pas simultanément la valeur qui devrait être la leur.

Dans un de ses modes de mise en oeuvre, l'invention concerne également un encodeur thermométrique destiné à recevoir un mot binaire d'entrée et à délivrer sur une sortie numérique un signal thermométrique, encodeur caractérisé en ce qu'il comporte :
. un convertisseur numérique/analogique destiné à délivrer un signal analogique représentatif du mot binaire d'entrée, et
. une pluralité de comparateurs, chacun muni d'une sortie destinée à délivrer un signal numérique représentatif du résultat d'une comparaison entre la valeur du signal analogique et une valeur de référence, les sorties des comparateurs formant la sortie numérique de l'encodeur thermométrique.

Dans ce mode de mise en oeuvre de l'invention, tous les bits du signal de sortie sont générés simultanément par les comparateurs, ce qui évite que des transitions parasites ne se produisent dans ledit signal de sortie.

Dans un mode de mise en oeuvre particulier de l'invention, le convertisseur numérique/analogique comporte :
. une pluralité de sources de courant, la conduction de chacune des sources de courant étant contrôlée par l'un des bits du mot binaire d'entrée, sources de courant disposées entre une première borne d'alimentation et une borne de sortie du convertisseur numérique/analogique destinée à délivrer le signal analogique, et
. un élément résistif disposé entre une deuxième borne d'alimentation et la borne de sortie du convertisseur numérique/analogique,
chaque comparateur étant muni de moyens pour mémoriser son propre signal de sortie.

Dans ce mode de mise en oeuvre de l'invention, le convertisseur numérique/analogique a une structure simple et peu coûteuse. Ceci est rendu possible grâce au fait que les comparateurs mémorisent leurs propres signaux de sortie, ce qui équivaut à une mémorisation du signal de sortie thermométrique. En effet, le convertisseur numérique/analogique décrit ci-dessus est vulnérable aux transitions parasites du mot binaire d'entrée. La mémorisation du signal de sortie thermométrique permet d'immuniser ledit signal contre des transitions parasites du signal analogique.

Pour obtenir une parfaite immunité du signal thermométrique de sortie à des transitions parasites du signal analogique, il faudrait en principe munir les comparateurs de cellules mémoire de type maître-esclave, c'est-à-dire deux bascules mémoire simples successives, cadencées par deux signaux d'horloge en opposition de phase. Une variante de ce mode de mise en oeuvre permet de diminuer de moitié la complexité des moyens dont sont munis les comparateurs pour mémoriser leurs signaux de sortie.

Selon cette variante, l'encodeur comporte des moyens pour mémoriser le signal analogique.

Ceci permet de munir les comparateurs de bascules mémoire simples, cadencées par un même signal d'horloge, les moyens pour mémoriser le signal analogique étant cadencés par un signal en opposition de phase avec ledit signal d'horloge.

Les signaux de référence utilisés pour la comparaison peuvent être générés par divers moyens, connus de l'homme de métier. Dans un mode de mise en oeuvre particulier de l'invention, l'encodeur décrit plus haut comporte en outre une première échelle de résistances disposée entre les première et deuxième bornes d'alimentation et destinée à être polarisée au moyen d'une source de courant dite de polarisation, une connexion entre deux résistances adjacentes étant destinée à générer un potentiel électrique constituant l'une des valeurs de référence auxquelles le signal analogique doit être comparé.

Une variante de l'encodeur décrit ci-dessus permet une calibration optimale et automatique des signaux de référence par rapport à la plage de variation du signal analogique. Selon cette variante, l'élément résistif indus dans le convertisseur numérique/analogique est constitué par une deuxième échelle de résistances, identique, à une résistance près, à la première échelle de résistances, la valeur maximale du courant susceptible de parcourir la deuxième échelle de résistances étant égale à la valeur du courant débité par la source de courant de polarisation.

Si la présente invention peut être utilisée dans tous types de systèmes nécessitant une conversion d'un mot binaire en un signal thermométrique, sa mise en oeuvre est particulièrement avantageuse dans un dispositif de conversion numérique/analogique.
L'invention concerne donc également un dispositif destiné à convertir un signal d'entrée numérique en un signal de sortie analogique, comprenant :
. une première et une deuxième batterie de sources de courant, dont des sorties sont interconnectées et sont destinées à délivrer le signal de sortie du dispositif, et
. un encodeur thermométrique dont le signal de sortie est destiné à contrôler la conduction de la première batterie de sources de courant, et dont le mot binaire d'entrée est constitué par les bits de poids faible du signal numérique d'entrée, les bits de poids fort dudit signal étant destinés à contrôler la conduction de la deuxième batterie de sources de courant,
dispositif caractérisé en ce que l'encodeur thermométrique est tel que décrit plus haut.

L'invention sera mieux comprise à l'aide de la description suivante, faite à titre d'exemple non-limitatif et en regard des dessins annexés, dans lesquels :
- la figure 1 est un schéma électrique décrivant un encodeur thermométrique mettant en oeuvre un procédé selon l'invention, et
- la figure 2 est un schéma fonctionnel décrivant un dispositif de conversion numérique/analogique incluant un tel encodeur.

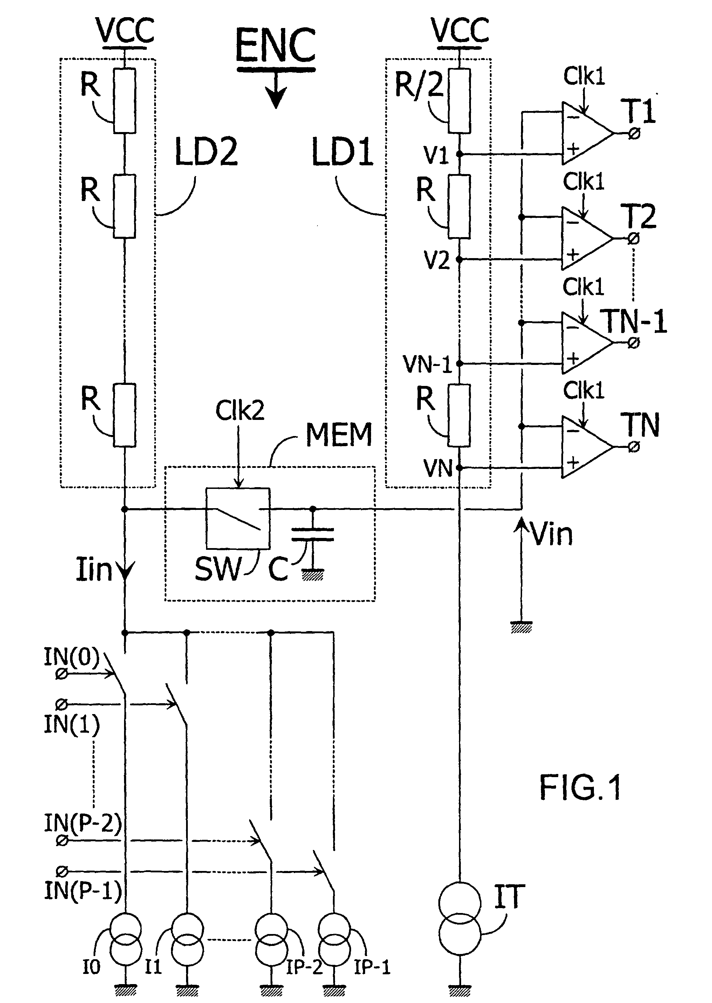

La figure 1 représente schématiquement un encodeur thermométrique ENC destiné à recevoir un mot binaire d'entrée IN(0:P-1) et à délivrer sur une sortie numérique un signal thermométrique T1...TN. Cet encodeur ENC comporte :
. un convertisseur numérique/analogique destiné à délivrer un signal analogique Vin représentatif du mot binaire d'entrée IN(0:P-1), et
. une pluralité de comparateurs, chacun muni d'une sortie destinée à délivrer un signal numérique Ti (pour i=1 à N) représentatif du résultat d'une comparaison entre la valeur du signal analogique Vin et une valeur de référence Vi, les sorties des comparateurs formant la sortie numérique de l'encodeur thermométrique.
L'encodeur thermométrique ENC comporte en outre une première échelle de N résistances LD1 disposées en série entre une première borne d'alimentation, matérialisée dans cet exemple par une masse, et une deuxième borne d'alimentation VCC, destinée à être polarisée au moyen d'une source de courant IT dite de polarisation. Chaque connexion entre deux résistances adjacentes est destinée à générer un potentiel électrique Vi (pour i=1 à N) constituant l'une des valeurs de référence auxquelles le signal analogique Vin doit être comparé.
Dans le mode de réalisation particulier décrit ici, le convertisseur numérique/analogique comprend une pluralité de sources de courant I0...IP-1, la conduction de chacune des sources de courant Ij (pour j=0 à P-1) étant contrôlée par l'un des bits IN(j) du mot binaire d'entrée IN(0:P-1). Les sources de courant pourront être construites de manière à ce que chacune génère un courant ayant une valeur pondérée en fonction du poids de celui des bits du mot binaire qui contrôle sa conduction. Ceci peut s'exprimer sous la forme Ij=2^{j}.I0 (pour j=0 à P-1).
Les sources de courant I0...IP-1 sont disposées entre la première borne d'alimentation et une borne de sortie du convertisseur numérique/analogique destinée à délivrer le signal analogique Vin. Le convertisseur numérique/analogique inclus dans l'encodeur ENC comporte en outre un élément résistif LD2 disposé entre la deuxième borne d'alimentation VCC et la borne de sortie du convertisseur numérique/analogique. Cet élément résistif est constitué par une deuxième échelle de résistances, identique à la première échelle de N résistances LD1, à ceci près que les résistances reliées à la deuxième borne d'alimentation VCC ont des valeurs différentes d'une échelle à l'autre. La valeur maximale du courant Iin susceptible de parcourir la deuxième échelle de N résistances LD2 est égale à la valeur du courant débité par la source de courant de polarisation IT. Ceci permet une calibration optimale et automatique des signaux de référence Vi par rapport à la plage de variation du signal analogique Vin.
Le fonctionnement de l'encodeur ENC peut être décrit comme suit : si, dans un premier temps aucun des bits du mot binaire d'entrée n'est au niveau logique 1, le signal analogique Vin est égal à VCC et est donc supérieur à toutes les valeurs de référence Vi. Tous les bits du signal de sortie thermométrique T1...TN sont donc au niveau logique 0. Si, dans un deuxième temps, seul le bit de poids le plus faible I(0) est au niveau logique 1, la valeur du signal analogique Vin est égale à VCC-N.R.I0, tandis que la première valeur de référence V1 est égale à VCC-IT.R/2, avec IT=I0+I1+...IP-1 , soit encore IT= Σ2^{j} .I0 . La valeur du signal analogique Vin devient donc inférieure à la première valeur de référence V1, mais reste supérieure à la deuxième valeur de référence V2. Seul le premier bit T1 du signal de sortie thermométrique T1...TN est donc au niveau logique 1, tous les autres étant au niveau logique 0. Lorsque, dans un troisième temps, seul le bit I(1) du mot binaire d'entrée I(0:P-1) est au niveau logique 1, la valeur du signal analogique Vin est égale à VCC-N.R.I1 et est donc inférieure à la deuxième valeur de référence V2, mais reste supérieure à la troisième valeur de référence. Les deux premiers bit T1 et T2 du signal de sortie thermométrique T1...TN sont donc au niveau logique 1, tous les autres étant au niveau logique 0. Ce raisonnement peut être développé jusqu'à ce que tous les bits du mot binaire d'entrée I(0:P-1) soient au niveau logique 1. La valeur du signal analogique Vin est alors égale à VCC-N.R.IT, alors que la Nième valeur de référence VN est égale à VCC-(N-1/2).R.IT. La valeur du signal analogique Vin est donc inférieure à la Niéme valeur de référence VN, et tous les bits du signal de sortie thermométrique T1...TN sont au niveau logique 1.

Chaque comparateur est muni de moyens pour mémoriser son propre signal de sortie. Ces moyens sont cadencés par un premier signal d'horloge Clk1. La mémorisation du signal de sortie thermométrique T1...TN permet d'immuniser T1...TN ledit signal contre des transitions parasites du signal analogique Vin, qui peuvent se produire lorsque tous les bits du mot binaire d'entrée IN(0:P-1) ne prennent pas simultanément la valeur qui devrait être la leur, provoquant ainsi des commutations non-simultanées des sources de courant I0...IP-1.
Pour obtenir une parfaite immunité du signal thermométrique de sortie T1...TN à des transitions parasites du signal analogique Vin, il faudrait en principe munir les comparateurs de cellules mémoire de type maître-esclave, constituées par deux bascules mémoire simples successives, cadencées par deux signaux d'horloge en opposition de phase, c'est à dire ici le premier signal d'horloge Clk1 et son complémentaire. Le mode de réalisation décrit ici permet de diminuer de moitié la complexité des moyens dont sont munis les comparateurs pour mémoriser leurs signaux de sortie : de simples bascules D, cadencées par le seul premier signal d'horloge Clk1, peuvent être utilisées à ces fins. L'encodeur ENC comporte en effet des moyens MEM pour mémoriser le signal analogique. Ces moyens comprennent un échantillonneur/bloqueur constitué d'un interrupteur SW et d'un élément capacitif C, et piloté par un deuxième signal d'horloge Clk2. Lorsque ce signal est à un niveau logique 1, l'interrupteur SW est fermé et l'élément capacitif C présente à ses bornes une tension, qui constitue le signal analogique Vin, qui reproduit la tension délivrée par la borne de sortie du convertisseur numérique/analogique.
Au bout d'un délai prédéterminé suffisant pour que tous les bits du mot binaire d'entrée aient pris la valeur qui doit être la leur, le deuxième signal d'horloge Clk2 est au niveau logique 0 et la valeur du signal analogique Vin est mémorisée par l'élément capacitif C. Cette valeur est comparée aux valeurs de référence Vi (pour i=1 à N), le résultat de ladite comparaison étant mémorisé à son tour par les bascules D dont sont munis les comparateurs lorsque le premier signal d'horloge Clk1 présente un front actif. La valeur du signal de sortie thermométrique T1...TN n'est donc pas vulnérable aux transitions parasites du mot binaire d'entrée IN(0:P-1).
Les premier et deuxième signaux d'horloge Clk1 et Clk2 seront avantageusement complémentaires entre eux, et dotés d'une fréquence égale au double de celle des variations du mot binaire d'entrée IN(0:P-1).

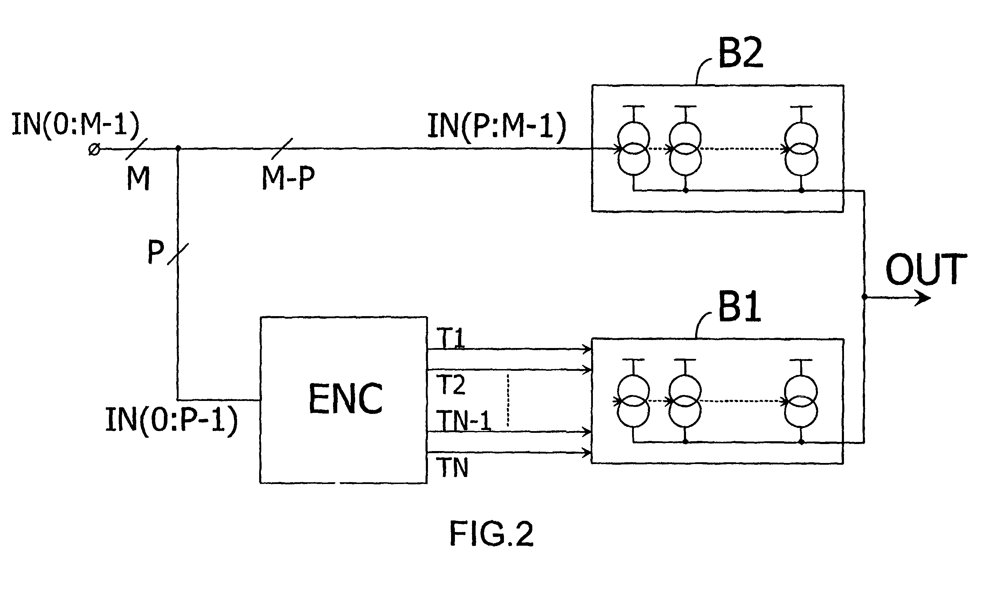

La figure 2 est un schéma fonctionnel qui représente un dispositif de conversion numérique/analogique qui inclut un encodeur binaire/thermométrique conforme à l'invention.
Ce dispositif est destiné à convertir un signal d'entrée numérique IN(0:M-1) en un signal de sortie analogique OUT, et comprend :
. une première et une deuxième batterie de sources de courant B1 et B2, dont des sorties sont interconnectées et sont destinées à délivrer le signal de sortie OUT du dispositif, et
. un encodeur thermométrique ENC dont le signal de sortie T1...TN est destiné à contrôler la conduction de la première batterie de sources de courant B1, et dont le mot binaire d'entrée IN(0:P-1) est constitué par les P bits de poids le plus faible du signal numérique d'entrée IN(0:M-1), les M-P bits de poids le plus fort IN(P:M-1) dudit signal IN(0:M-1) étant destinés à contrôler la conduction de la deuxième batterie de sources de courant B2. Dans ce dispositif, l'encodeur thermométrique ENC est conforme à la description qui précède.
Ceci permet de simplifier la structure d'ensemble du dispositif et de diminuer sa consommation énergétique, tout en l'autorisant à traiter des signaux d'entrée numériques ayant une fréquence de variation supérieure à 100MHz. De plus, le signal de sortie thermométrique de l'encodeur ENC étant, dans une large mesure, immunisé contre des transitions parasites que pourraient présenter les P bits de poids le faible du signal numérique d'entrée IN(0:M-1), le signal de sortie OUT bénéficie lui aussi d'une telle immunité, ce qui confère une excellente résolution à la conversion opérée par le dispositif.

## Revendications

1. Procédé pour convertir un mot binaire (IN(0:P-1)) en un signal thermométrique (T(1:N), ledit procédé comportant :
- une étape de conversion du mot binaire (IN(0:P-1)) en un signal analogique (Vin),
- une étape de comparaison dudit signal analogique (Vin) avec une pluralité de signaux de référence (V1...VN), pour générer un ensemble de signaux logiques (T1...TN) définissant ledit signal thermométrique (T(1:N)).

2. Procédé selon la revendication 1, comportant une étape de mémorisation dudit signal analogique (Vin), ladite étape de mémorisation étant insérée entre l'étape de conversion et l'étape de comparaison.

3. Encodeur thermométrique destiné à recevoir un mot binaire d'entrée (IN(0:P-1)) et à délivrer sur une sortie numérique un signal thermométrique (T(1:N)), ledit encodeur thermométrique comportant :
- un convertisseur numérique/analogique destiné à délivrer un signal analogique (Vin) représentatif du mot binaire d'entrée (IN(0:P-1)),
- une pluralité de comparateurs, chacun muni d'une sortie destinée à délivrer un signal numérique (T1...TN) représentatif du résultat d'une comparaison entre la valeur du signal analogique (Vin) et une valeur de référence (Vⱼ), les sorties des comparateurs formant la sortie numérique de l'encodeur thermométrique.

4. Encodeur thermométrique selon la revendication 3, dans lequel le convertisseur numérique/analogique comporte :
- une pluralité de sources de courant (I0... IP-1), la conduction de chacune des sources de courant (1j) étant contrôlée par l'un des bits (IN(j)) du mot binaire d'entrée (IN(O:P-1)), sources de courant disposées entre une première borne d'alimentation (GND) et une borne de sortie du convertisseur numérique/analogique destinée à délivrer le signal analogique (Vin),
- un élément résistif (LD2) disposé entre une deuxième borne d'alimentation (VCC) et la borne de sortie du convertisseur numérique/analogique,
chaque comparateur étant muni de moyens pour mémoriser son propre signal de sortie.

5. Encodeur thermométrique selon la revendication 3 ou 4, comportant des moyens (MEM) pour mémoriser le signal analogique (Vin).

6. Encodeur thermométrique selon la revendication 3, 4 ou 5, comportant en outre une première échelle de résistances (LD1) disposée entre les première et deuxième bornes d'alimentation (GND,VCC) et destinée à être polarisée au moyen d'une source de courant de polarisation (IT), une connexion entre deux résistances adjacentes étant destinée à générer un potentiel électrique constituant l'une des valeurs de référence (Vj) auxquelles le signal analogique (Vin) est destiné à être comparé.

7. Encodeur thermométrique selon la revendication 3, 4, 5 ou 6, dans lequel l'élément résistif (LD2) inclus dans le convertisseur numérique/analogique est constitué par une deuxième échelle de résistances, identique, à une résistance près, à la première échelle de résistances (LD1), la valeur maximale du courant susceptible de parcourir la deuxième échelle de résistances étant égale à la valeur du courant débité par la source de courant de polarisation (IT).

8. Dispositif destiné à convertir un signal d'entrée numérique (IN(0:M-1)) en un signal de sortie analogique (OUT), ledit dispositif comprenant :
- une première batterie de sources de courant (B1) et une deuxième batterie de sources de courant (B2) ayant des sorties interconnectées et destinées à délivrer ledit signal de sortie analogique (OUT),
- un encodeur thermométrique (ENC) conforme à la revendication 3 destiné à fournir un signal de sortie (T(1:N)) pour contrôler la conduction de la première batterie de sources de courant (B1), et à recevoir un mot binaire d'entrée (IN(0:P-1)) constitué par les bits de poids faible (IN(0) ... IN(P-1)) du signal numérique d'entrée (IN(0:M-1)), les bits de poids fort (IN(P)...IN(M-1)) dudit signal d'entrée (IN(0:M-1)) étant destinés à contrôler la conduction de la deuxième batterie de sources de courant (B2).

## Patentansprüche

1. Verfahren zum Umwandeln eines binären Worts (IN(0:P-1)) in ein thermometrisches Signal (T(1:N), wobei das besagte Verfahren enthält:
- einen Schritt zur Umwandlung des binären Worts (IN(0:P-1)) in ein analoges Signal (Vin),
- einen Schritt zum Vergleichen des besagten analogen Signals (Vin) mit einer Vielzahl von Referenzsignalen (V1... VN), um eine Einheit logischer Signale (T1...TN) zu erzeugen, welche das besagte thermometrische Signal (T(1:N)) definieren.

2. Verfahren nach Anspruch 1 mit einem Schritt zum Speichern des besagten analogen Signals (Vin), wobei der besagte Schritt zum Speichern zwischen den Schritt zum Umwandeln und den Schritt zum Vergleichen eingefügt wird.

3. Thermometrischer Kodierer für den Erhalt eines binären Eingangsworts (IN(0:P-1) und die Ausgabe an einem digitalen Ausgang eines thermometrischen Signals (T(1:N), wobei der besagte thermometrische Kodierer enthält:
- einen Digital/Analog-Wandler für die Ausgabe eines das binäre Eingangswort IN(0:P- 1)darstellenden analogen Signals (Vin),
- eine Vielzahl von Vergleichern, jeweils mit einem dafür bestimmten Ausgang ausgestattet, ein das Ergebnis eines Vergleichs zwischen dem Wert des analogen Signals (Vin) und einem Referenzwert (Vi) darstellendes digitales Signal (T1...TN) auszugeben, wobei die Ausgänge der Vergleicher den digitalen Ausgang des thermometrischen Kodierers bilden.

4. Thermometrischer Kodierer nach Anspruch 3, in dem der Digital/Analog-Wandler enthält:
- eine Vielzahl von Stromquellen (I0 ... IP-1), wobei die Leitung jeder der Stromquellen (Ij) von einem der Bits (IN(j) des binären Eingangsworts (IN(0:P-1) gesteuert wird und die Stromquellen zwischen einer ersten Versorgungsklemme (GND) und einer Ausgangsklemme des Digital/Analog-Wandlers für die Ausgabe des analogen Signals (Vin) angeordnet sind;
- ein resistives Element (LD2), zwischen einer zweiten Versorgungsklemme (VCC) und der Ausgangsklemme des Digital/Analog-Wandlers angeordnet,
wobei jeder Vergleicher mit Mitteln zum Abspeichern seines eigenen Ausgangssignals ausgestattet ist.

5. Thermometrischer Kodierer nach Anspruch 3 oder 4 mit Mitteln (MEM) zum Abspeichern des analogen Signals (Vin).

6. Thermometrischer Kodierer nach Anspruch 3, 4 oder 5 mit außerdem einer ersten Widerstandsstufe (LD1), zwischen der ersten und zweiten Versorgungsklemme (GND, VCC) angeordnet und dafür bestimmt, mittels einer Polarisations-Stromquelle (IT) polarisiert zu werden, wobei eine Verbindung zwischen zwei angrenzenden Widerständen dazu bestimmt ist, ein elektrisches Potenzial zu erzeugen, welches einen der Referenzwerte (Vj) bildet, mit dem das analoge Signal (Vin) verglichen werden muss.

7. Kodierer nach Anspruch 3, 4, 5 oder 6, in dem das im Digital/Analog-Wandler enthaltene resistive Element (LD2) aus einer zweiten Widerstandsstufe gebildet wird, bis auf einen Widerstand mit der ersten Widerstandsstufe (LD1) identisch, wobei der maximale Wert des gegebenenfalls durch die zweite Widerstandsstufe fließenden Stroms gleich dem Wert des von der Polarisations-Stromquelle (IT) abgegebenen Stroms ist.

8. Vorrichtung zum Umwandeln eines digitalen Eingangssignals (IN(0:M-1)) in ein analoges Ausgangssignal (OUT), wobei die besagte Vorrichtung enthält:
- einen ersten Akkumulator der Stromquellen (B1) und einen zweiten Akkumulator der Stromquellen (B2) mit miteinander verbundenen Ausgängen und dafür bestimmt, das besagte analoge Ausgangssignal (OUT) auszugeben,
- einen thermometrischen Kodierer (ENC) entsprechend Anspruch 3 für die Ausgabe eines Ausgangssignals (T(1:N) zum Steuern der Leitung des ersten Akkumulators der Stromquellen (B1) und für den Erhalt eines binären Eingangsworts, (IN(0:P-1) gebildet von den Bits geringen Stellenwerts (IN(0) ... JIN(P-1) des digitalen Eingangssignals (IN(0:M-1), wobei die Bits großen Stellenwerts (IN(P)...IN(M-1) des besagten Eingangssignals (IN(0:M-1)) dafür bestimmt sind, die Leitung des zweiten Akkumulators der Stromquellen (B2) zu steuern.

## Claims

1. A method of converting a binary word (IN(0:P-1)) into a thermometric signal (T(1:N)), said method comprising:
• a conversion stage where the binary word (IN(0:F-1)) is converted into an analog signal (Vin), and
• a comparison stage where said analog signal (Vin) is compared with a plurality of reference signals (V1...VN) to generate an array of logic signals (T1...TN) defining said thermometric signal (T(1:N)).

2. A method as claimed in claim 1, comprising a step of storing said analog signal (Vin), which step is inserted between the conversion step and the comparison step.

3. A thermometric encoder for receiving a binary input word (IN(0:P-1)) and for supplying a thermometric signal (T(1:N)) to a digital output, which thermometric encoder comprises:
• a digital-to-analog converter which serves to supply an analog signal (Vin) which is representative of the binary input word (IN(0:P-1)),
• a plurality of comparators each of which is provided with an output for delivering a digital signal (T1...TN) which is representative of the result of a comparison between the value of the analog signal (Vin) and a reference value (Vⱼ), the outputs of the comparators forming the digital output of the thermometric encoder.

4. A thermometric encoder as claimed in claim 3, wherein the digital-to-analog converter comprises:
• a plurality of current sources (IO... IP-1), the conduction of each one of the current sources (Ij) being controlled by one of the bits (IN(j)) of the binary input word (IN(0:P-1)), said current sources being arranged between a first supply terminal (GND) and an output terminal of the digital-to-analog converter, said output terminal serving to supply the analog signal (Vin),
• a resistive element (LD2) arranged between a second supply terminal (VCC) and the output terminal of the digital-to-analog converter,
each comparator being provided with means for storing its own output signal.

5. A thermometric encoder as claimed in claim 3 or 4, comprising means (MEM) for storing the analog signal (Vin).

6. A thermometric encoder as claimed in claim 3, 4 or 5, comprising, in addition, a first scale of resistances (LD1) which are connected between the first and the second supply terminals (GND, VCC) and which scale is to be polarized by means of a polarization current source (IT), a connection between two adjacent resistances being used to generate an electric potential forming one of the reference values (Vj) with which the analog signal (Vin) is to be compared.

7. A thermometric encoder as claimed in claim 3, 4, 5 or 6, wherein the resistive element (LD2) included in the digital-to-analog converter is composed of a second scale of resistances which, apart from one resistance, is identical to the first scale of resistances (LD1), the maximum value of the current which is capable of traversing the second scale of resistances being equal to the value of the current produced by the polarization current source (IT).

8. A device which is used to convert a digital input signal (IN(0:M-1);) into an analog output signal (OUT), comprising:
• a first array of current sources (B1) and a second array of current sources (B2), having interconnected outputs and serving to supply said analog output signal,
a thermometric encoder (ENC) as claimed in claim 3, which is used to supply an output signal (T(1:N)) to control the conduction of the first array of current sources (B1), and to receive an input binary word (IN(0:P-1)) which is formed by bits of low weight (IN(O)...IN(P-1)) of the digital input signal (IN(0:M-1)), the heavy-weight bits (IN(P)...IN(M-1)) of this input signal (IN(0:M-1)) being used to control the conduction of the second array of current sources (B2).
